(19) Europäisches Patentamt
European Patent Office
Office européen des brevets

(11) **EP 4 057 066 A1**

(12) **EUROPEAN PATENT APPLICATION**

(43) Date of publication:
**14.09.2022  Bulletin 2022/37**

(51) International Patent Classification (IPC):
***G03F 7/00*** *(2006.01)*

(21) Application number: **21161914.3**

(52) Cooperative Patent Classification (CPC):
**G03F 7/0002**

(22) Date of filing: **11.03.2021**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Obducat AB**
**22363 Lund (SE)**

(72) Inventors:
 • **Venkatesh Krishnan, Prasanna**
 **22363 Lund (SE)**

 • **Thulin, Kristian**
 **22363 Lund (SE)**
 • **Ring, Johan**
 **22363 Lund (SE)**
 • **Larsson, Kristian**
 **22363 Lund (SE)**
 • **Gustavsson, Mikael**
 **22363 Lund (SE)**

(74) Representative: **Neij & Lindberg AB**
**Pedellgatan 11**
**224 60 Lund (SE)**

(54) **APPARATUS AND METHOD FOR SURFACE TREATMENT OF AN IMPRINT STAMP**

(57)    Apparatus (70) and method for surface treatment of an imprint stamp (10) having a structured stamp surface (11) for use in nano imprint lithography. The method comprises:
providing the imprint stamp (10) into a sealed plasma chamber (21);
supplying a process gas to the plasma chamber;
generating a plasma from the process gas in the plasma chamber to deposit a coating on the stamp surface;
removing the imprint stamp from the plasma chamber.

Fig.7A

EP 4 057 066 A1

## Description

### Technical field

The present invention relates to the field of imprint lithography, and specifically to a process for surface treatment of an imprint stamp having a structured stamp surface for use in imprint lithography.

### Background

Imprint lithography is a technique for surface pattern replication, which is particularly suitable for transfer of small scale patterns. The technique involves a process for transferring a pattern from a template or stamp to an object by contacting a structured surface of the template or stamp with a moldable layer on a target surface of the object. The moldable layer is subsequently processed to harden, or cure, and once the template or stamp has been removed from the object, an inverse replica is formed in the target surface. Imprint technology has proven to be one of the most powerful techniques for reproducing nano structures, i.e. structures in the order of 100 nm or smaller and is therefore generally referred to as nanoimprint lithography (NIL) when operated for transfer of patterns at such a scale. Specifically, NIL is advantageous for pattern transfer of large surfaces, such as up to 500x500 mm or larger.

A master template in which the pattern is formed must be produced with high accuracy, since any error in the master template is transferred to its replicas. The master template moreover needs to be durable, so to be able to be used repeatedly. A delicate process which may cause damage to the master template or the imprinted object is the step of disassembling the two after the imprint step. The instant applicant was therefore one of the pioneers in developing a technique for transferring micro and nano scale patterns from master templates to produce final product substrates by using a two-step process of imprinting. This has inter alia been described in EP1959299A2. In a first step, an Intermediate Polymer Stamp (IPS) is created by imprint of the master template into a polymer foil. After demolding of the IPS from the master template, the IPS is subsequently used for transferring its imprinted pattern to final substrates in a second imprint step. This normally involves providing a moldable layer, commonly referred to as a resist, on the substrate, and imprinting the patterned IPS surface into the resist. One advantage with such a process is that the IPS is flexible and can thus be disassembled from the master template in the first step, and from the imprinted substate in the second step, with minimized risk for causing damage to the mater template and to pattern imprinted in the resist on the substrate.

The imprint process is thus a technique involving contact and disassembly. Moreover, the process may in various cases involve application of heat and/or radiation, for making a surface layer moldable and subsequently hardening the structures imprinted in the moldable layer. All these parameters and requirements place constraints on the possible materials that may be employed. This is particularly the case for a two-step imprint process, wherein IPS needs to be provided using materials which are suitable for use with both the master template and the target substrate.

Therefore, there still exists a need for improvement in the field of imprint technology.

### Summary

The invention seeks to provide an improvement in the art of imprint apparatuses and processes. This includes the object of obtaining solutions for increasing productivity and efficiency of the process. In one aspect, this involves the object of increasing the lifetime of an imprint mater template. In another aspect, this involves the object of minimizing the risk for damage caused on imprinted structures. Yet another aspect of this objective is to provide solutions for a more time-effective imprint process.

The objectives are targeted by the invention as set out in the independent claims.

According to a first aspect, the invention relates to a method for surface treatment of an imprint stamp having a structured stamp surface for use in nano imprint lithography, comprising:

> providing the imprint stamp into a sealed plasma chamber;
> supplying a process gas to the plasma chamber;
> generating a plasma from the process gas in the plasma chamber to deposit a coating on the stamp surface;
> removing the imprint stamp from the plasma chamber.

According to a second aspect, the invention relates to an imprint apparatus, comprising:

> a sealed plasma chamber configured for coating an imprint stamp held in the chamber by plasma generation of a process gas, to obtain a coated structured stamp surface on the imprint stamp;
> a substrate imprint station, configured to apply pressure to press the imprint stamp against a substrate to transfer a pattern of the coated stamp surface to a moldable layer on a target surface of the substrate.

Further details of various advantageous embodiments are set out in the dependent claims.

By means of the proposed solution, a mechanism for affecting the surface chemistry of the stamp is provided. Specifically, the deposition of a coating by means of a plasma process provides for affecting adhesion properties of the stamp.

Brief description of the drawings

The proposed solution and various embodiments thereof will be described in more detail below with reference to the accompanying drawings, on which

Fig. 1 schematically illustrates an imprint stamp having a structured surface;

Fig. 2 schematically illustrates a plasma system comprising a sealed plasma chamber usable in various embodiments of the proposed solution;

Figs 3A and 3B schematically illustrate a plasma chamber used for coating a surface of the stamp according to an example;

Fig. 4 schematically illustrates an imprint stamp having a structured surface which has been coated in a plasma process according to one example;

Fig. 5 schematically illustrates a series of imprint stamps formed on a ribbon-shaped polymer foil, usable in a two-step imprint process;

Figs 6A-6D schematically illustrates iterated surface treatment, using a plasma chamber, of a polymer foil as exemplified in Fig. 5;

Figs 7A-7B schematically illustrates operation of an imprint apparatus and process, comprising the proposed surface treatment process;

Fig. 8 schematically illustrates an imprint apparatus configured to operate a two-step imprint process including the proposed surface treatment process;

Figs 9A-9E schematically illustrates an imprint step with automated subsequent disassembly or demolding, according to various examples;

Fig. 10 is a flowchart of method steps included in various embodiments; and

Figs 11-13 provide measurements obtained for different examples of patterns transferred using a stamp process according to various embodiments.

Detailed description

Embodiments of the present invention will hereinafter be described in more details with reference to the accompanying drawings. This invention may, however, be embodied in many different forms and should not be construed as limited to the embodiments set forth herein. Rather, these embodiments are provided so that this disclosure will be thorough and complete and will fully convey the scope of the invention to those skilled in the art. Unless otherwise defined, all terms (including technical and scientific terms) used herein have the same meaning as commonly understood by one of ordinary skill in the art to which this invention belongs. It will be further understood that terms used herein should be interpreted as having a meaning that is consistent with their meaning in the context of this specification and the relevant art and will not be interpreted in an idealized or overly formal sense unless expressly so defined herein. The terminology used herein is for describing particular embodiments only and it is not intended to be limiting of the invention. As used herein, the singular forms "a", "an" and "the" are intended to include the plural forms as well, unless the context clearly indicates otherwise. It will be further understood that the terms "comprises" "comprising," "includes" and/or "including" and the like, when used herein, specify the presence of stated features, integers, steps, operations, elements, and/or components, but do not preclude the presence or addition of one or more other features, integers, steps, operations, elements, components, and/or groups thereof.

The proposed solutions are related to surface treatment of imprint stamps, usable for imprint lithography. This relates, in various embodiments, to imprint stamps for nanoimprint lithography. The proposed solution stems from problems identified in the field of two-step imprint lithography, where an intermediate stamp is made of a flexible material, such as a polymer material. While the proposed solution may be employed for other types of imprint stamps, the embodiments described herein will predominantly be outlined for such flexible stamps.

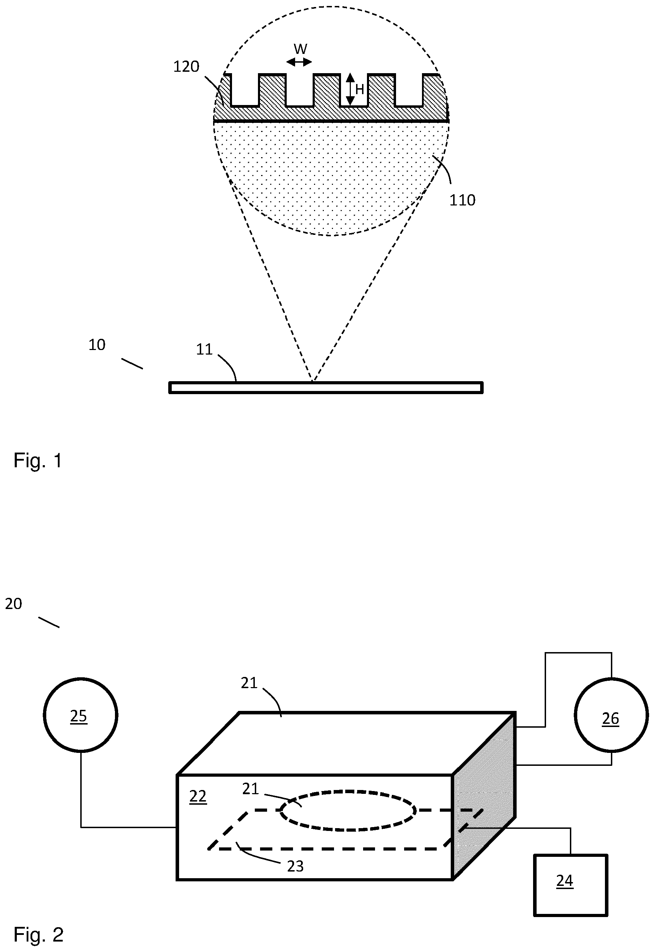

Fig. 1 schematically illustrates a stamp 10, having a structured stamp surface 11. A cross-section of a magnified portion of the stamp 10 is shown at the top of the drawing, indicating a part of the structures identifying a three-dimensional pattern in the surface 11. The structures may include a variety of shapes, and the shown portion is merely an example, having a pattern width W and depth D. As noted, in the field of nanoimprint lithography, the width W and/or the depth D may be in the nanometer region, such as being smaller than 1 micrometer. The stamp 10 may be provided with the structures in a layer 120, provide on top of a body portion 110. The layer 120 may be a separately coated film on top of a base or substrate 110, where the base 110 and the layer 120 may be of different materials. Alternatively, the layer 120 may simply be a portion of a single material stamp 10, where the layer 120 is defined as a portion stretching from a surface of the object down to a certain depth into the bulk of the stamp 10. The structures may in various embodiments be formed by heating up the stamp 10 above a glass transition temperature $T_g$ of the polymer material of the layer 120, after which a template is imprinted into the thus moldable layer 120 to imprint the pattern, followed by cooling down to below said glass transition temperature during the imprinting. This may be referred to as a hot embossing process. Alternatively, or additionally, the polymer of the layer 120 may be cured or cross-linked with the help of UV-light exposure during the imprinting process. A stamp 10 formed of a polymer foil may thus be provided as a flexible and optionally transparent foil comprising a thermoplastic polymer, a thermosetting polymer, and/or a polymer or pre-polymer which is cross-linked upon exposure to radiation, such as acrylic copolymers blended with UV curable oligomers.

With the increasing interest in nanoimprint lithography as a technology targeting a wide range of applications, the choice of materials available for creating polymer stamps 10 template, and resist layers for application on the substrate to be imprinted by means of the stamp 10, has seen a multi-fold increase. This, however, presents another challenge of compatibility between the two. In production of polymer stamps, UV-curable polymer layers 120 offer several advantages over a thermally cured materials, since such radiation processes obtain shorter cycle times and lower operating pressure. Moreover, thermal cycling may cause thermal stress resulting in distortion and possibly loss of durability of the master template used for imprinting the pattern in the stamp layer 120. This makes the use of UV-curable materials an ideal candidate for adoption in the industry for imprinting the layer 120.

An important feature to consider in the field of imprint technology is the surface energy, or surface tension, of the materials that are used. From a theoretical standpoint, a molecule located within a liquid is exposed to attractive forces (cohesion) from all directions from its surrounding molecules. These forces are compensating each other when the separation distance between molecule and surface is sufficiently large. However, when the separation between molecule and surface is smaller than the range of its molecular forces, a resulting traction appears perpendicular to the surface towards the centre of the liquid. This fact implies that work is necessary to move a molecule from the centre of the liquid to its surface, or in other words, molecules located near the surface have higher potential energy compared to those located closer to the centre. The extent of the required work needed to create a surface per area is defined as the surface energy, specific surface energy, or surface energy per area measured in units $mJ/m^2$, or $ergs/cm^2$. On the other hand, mechanically, force is necessary to increase a surface because the liquid tries to minimise its surface area itself as much as possible. The force acting on the edges of the surface per length of these edges is defined as the surface tension, measured in newton $meter^{-1}$ (N/m), mN/m, or dynes $cm^{-1}$. In the case of liquids, the terms "specific surface energy" and "surface tension" are synonyms, normally abbreviated by "$\sigma$" or "$\Upsilon$". When given herein, surface tension levels represent values at 25°C, but the values usually decrease with increasing temperature. Even for a solid material, work is necessary to create or to increase a surface. Since the bulk of a solid does not cleave spontaneously, the internal energy of the system must increase when a surface is created, for instance by a cleavage process. In the same manner as observed for a liquid, the specific surface energy for a solid is also defined as the constant of proportionality between the increase of internal energy of a system and its created surface area. It should also be noted that the specific surface energy as such is not only dependent on the choice of material, but also for instance on the topography of the surface. The lowest surface energies demonstrate atomically flat surfaces of defect-free single crystals. However, here the crystallographic structure of the surface is modified compared to that of the bulk, leading in the most cases to a more roughen super lattice, which is established to minimise the specific surface energy.

In an imprint process, two surfaces pressed together at imprint will subsequently have to be disassembled. In order for this to be carried out such that the transferred pattern is maintained without damage, and without requiring complicated and/or time-consuming processes, the surface chemistry of the mating surfaces may therefore be suitably configured. This involves considering the surface energy, as outlined above. Specifically, for a two-step process, the surfaces of the master template and that of the polymer material from which the flexible polymer stamp 10 is produced must exhibit sufficient anti-adhesion or anti-sticking properties against each other in order to release the polymer stamp from the template after performed imprint without causing damage to the pattern. Furthermore, in the secondary step, the material of the surface of the flexible polymer stamp 10 must exhibit sufficient anti-adhesion properties against the resist material layer on the substrate. This may be expressed as

$$\sigma_{\text{(template material)}} < \sigma_{\text{(polymer material)}}$$

and

$$\sigma_{\text{(polymer material)}} < \sigma_{\text{(resist material)}}$$

Here, template material refers to the material of the surface contacted with the polymer material, which therefore may refer to an anti-sticking layer of the template if such a layer is provided.

It has been found that COC polymer materials with a surface tension in the range of 28-40 mN/m, lead to pronounced anti-adhesion properties against other materials, making it ideal to apply them in the imprint process, for instance as an imprint layer of the polymer foil. It should be noted, though, that not all COCs have a surface tension within this range. However, several factors limit the widespread use of COC materials in industrial application. Slower cycle times due to thermal cycling in the process, inability to use an imprinted polymer foil as a template for multiple substrate imprints and relatively high cost of raw material result in a high cost of ownership.

An objective is to provide a solution to improve material compatibility for mating surfaces in an imprint process, suitable to be employed industrially. Specifically, this is relevant for flexible polymer stamps, which as such may be formed in a first stamp forming imprint step, and subsequently used as a stamp in a second substrate imprint step, according to the mentioned two-step imprint process.

With reference to the equations above, it may be identified that drawbacks are obtained if surface tension 'σ' in the second step is comparable, i.e.:

$$\sigma_{solid/liquid} \text{ (polymer material)} \sim \sigma_{liquid} \text{ (resist material)}.$$

Specifically, this will be inherently detrimental to imprint lithography causing high peel-strength or demolding forces, leading to a loss in replication fidelity. This is thus a relation that needs to be avoided. In certain cases, the polymer material in the surface layer 120 and the resist material on the substrate to be imprinted can even be chemically compatible, making a demolding extremely difficult or even destructive.

The solution proposed herein is to prepare the stamp 10, such as a flexible polymer stamp 10, by application of a coating to affect its surface chemistry. Specifically, this may be carried out to lower the surface tension of the stamp 10. According to the proposed solution, the coating is provided by employing a plasma process.

Fig. 2 schematically illustrates a surface coating apparatus 20, including a plasma chamber 21. The plasma chamber 21, which is only schematically illustrated in Fig. 2, may be closed to a sealed arrangement to define a chamber cavity 22. The plasma chamber is configured to house a stamp 10, having a stamp surface 11 to be treated. At least one electrode 23 is arranged in the chamber cavity 22, and connected to a power supply control device 24, which is configured to provide electrical energy to the electrode 23 so as to induce a plasma process. A gas supply mechanism 25 is further connected to the plasma chamber 21, to supply one or more components of a process gas to the chamber cavity 22 of the plasma chamber 21 at controlled supply levels. A pressure control mechanism 26 is connected to control with controlled pressure of the chamber cavity for the plasma process. The pressure control mechanism 26 may comprise one or more pumps, such as at least one vacuum pump configured to supply a controlled vacuum level to the chamber cavity 22. In some embodiments, the pressure control mechanism 26 comprises a roughening pump provided with a booster pump, enabling fast pump down without requiring a turbo pump. In operation, when the proper pressure has been obtained by means of the pressure control mechanism 26, and the process gas has been supplied to the plasma chamber 21 at the controlled proper supply level by means of the gas supply mechanism 25, the power supply control device 24 is configured to provide electrical energy to the electrode 23 to generate a plasma from the process gas in the plasma chamber to deposit a coating on the stamp surface 11 of the stamp.

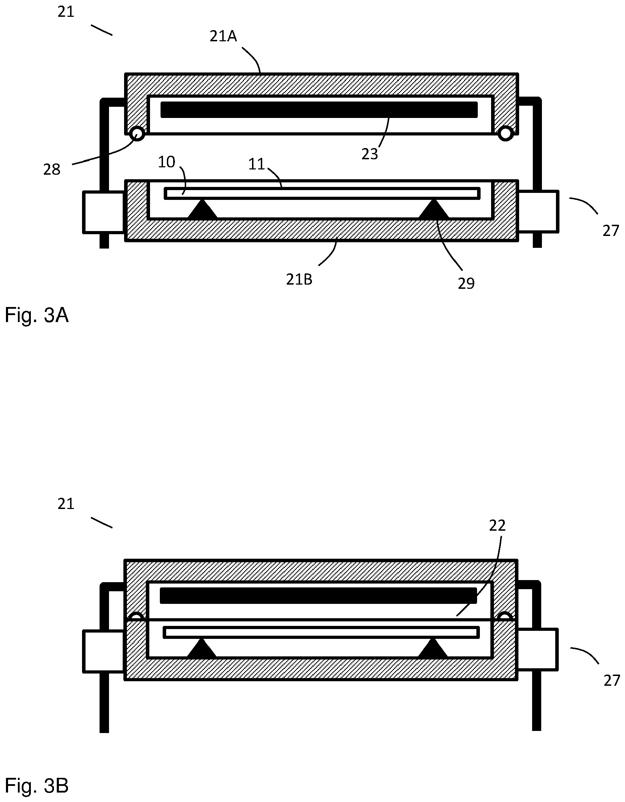

Figs 3A and 3B schematically illustrate one example of the plasma chamber 21. Here, the plasma chamber comprises two wall members 21A and 21B which may be controlled to an open arrangement as shown in Fig. 3A, and to a closed arrangement as shown in Fig. 3B. This operation is operated by a closure mechanism 27, schematically illustrated in the drawing, such as a mechanical, pneumatic, or hydraulic arrangement for clamping the chamber wall members 21A, 21B into the closed and sealed arrangement of Fig. 3B to confine the chamber cavity 22. For this purpose, a sealing member 28 may be provided at an engagement surface of at least one of the chamber wall members 21A, 21B. A support mechanism 29 may further be provided for supporting an object, such as the stamp 10, in the chamber 20. In the arrangement of the chamber 20 as shown in Fig. 3B, the stamp 10 is supported inside the chamber cavity 22, in which the plasma electrode 23 is supported. In Figs 3A and 3B the connected systems 24, 25, 26 for operating the plasma process are left out for the sake of simplicity.

According to one aspect, a method is thus provided for surface treatment of an imprint stamp 10, having a structured stamp surface 11 for use in nano imprint lithography. The method comprises:

    providing the imprint stamp 10 into a sealed plasma chamber 21;
    supplying a process gas to the plasma chamber;
    generating a plasma from the process gas in the plasma chamber to deposit a coating on the stamp surface;
    removing the imprint stamp 10 from the plasma chamber 21.

The proposed method thus provides a surface coating apparatus 20 for depositing a coating on a structured surface of stamp 10. Advantageously, the stamp 10 is a polymer replica made from a master template, wherein the surface coating apparatus 20 is integrated into a nano-imprint lithography apparatus. However, the surface coating apparatus 20 can also be free-standing, in which case it will be more suitable for lower volume production and offer a greater flexibility in materials.

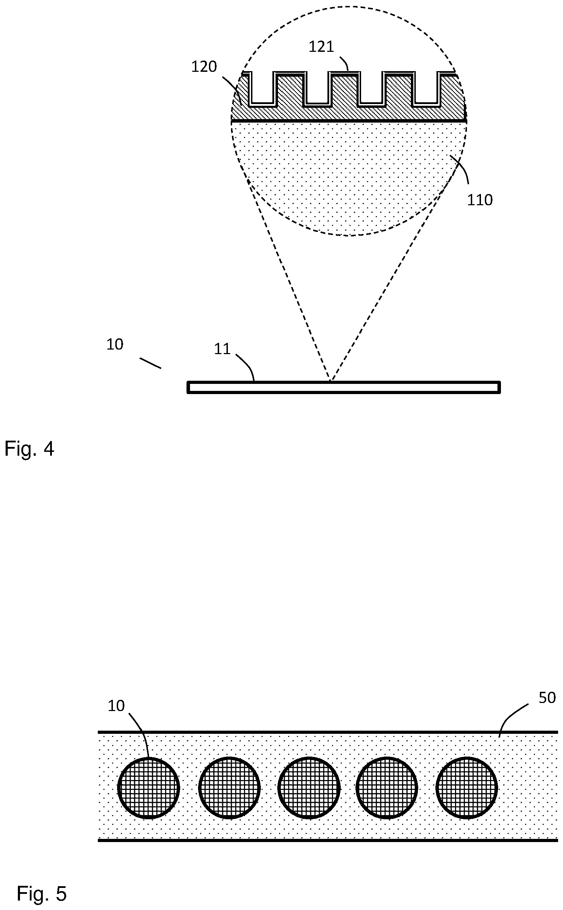

Fig. 4 schematically illustrates a stamp 10 which has been subjected to the surface coating process according to any of the embodiments outlined herein. A coating 121 is thus provided over the structured stamp surface forming the pattern. The coating may provide decreased surface energy, such as decreased specific surface energy or surface tension, of the thus coated stamp surface 11. The modified specific surface energy can then be described as:

$$\sigma_{(template\ material)} < \sigma_{(polymer\ material)}$$

and

$$\sigma_{(polymer\ material\text{-}antisticked)} < \sigma_{(resist\ material)}$$

In imprint lithography, and particularly in nanoimprint lithography, the template, also referred as the master, is generally a high cost product. Wear or damages to the template should therefore be minimized. The template may be made of any material, but is often made of Si, Ni or other metal, or quartz. On the other hand, the object to be imprinted, herein referred to as the substrate, is often made of a relatively hard material, such as silicon or other semiconductor material, which is coated with a comparatively soft moldable imprint layer. The step of imprinting the substrate is a crucial moment, where parallel arrangement is important, and a very small residual layer of the moldable layer is desired, often in the order of or less than 5 nm, under the deepest imprinted structures. Any non-parallel arrangement or excessive pressure may therefore cause damage to the template. In the two-step imprint method, the template will only be used against a polymer material of the intermediate stamp 10, which is softer than the template material, thereby minimizing the risk of damage.

By means of employing the proposed coating technique, an increased degree of freedom in terms of selecting material involved in the two-step imprint process is obtained. The surface layer 120 of the polymer stamp may be suitably selected to provide anti-sticking properties against the template surface, which may be pre-treated with an anti-sticking coating. Moreover, suitable post-treatment of the created polymer stamp 10 by employing the plasma processing of a process gas may be designed to obtain suitable anti-sticking properties with respect to a resist layer used on the substrate. In combination with the flexible character of the polymer stamp 10, disassembly of the polymer stamp in both the first step and in the second step provides for an improved overall imprint process.

In various embodiments, an imprint apparatus is configured to comprise the surface coating apparatus 20, including a plasma chamber 21. In some embodiments, the imprint apparatus is configured to employ the mentioned two-step process of lithography. For reference, various details of the two-step process are outlined in applicant's prior publication EP1795497A1.

In various embodiments, the stamp 10, specifically referred to as an intermediate stamp in the case of a two-step process, may be produced from a continuous web of polymer material. Fig. 5 schematically illustrates such web, wherein one or more imprint stamps 10 are formed as respective surface portions of a polymer ribbon 50 which acts as a stamp carrier. Once imprinted to form the stamps 10, each of said stamps may have the character as shown in Fig. 1 and described with reference thereto.

The ribbon-shaped stamp carrier 50, on which the stamps 10 are subsequently formed to obtain the character of Fig. 5, may comprise a carrier polymer material 110, e.g. polyester, which may be less than 200 $\mu$m, such as 100 $\mu$m or less, in thickness. On top of the carrier polymer material 110, a moldable layer is provided, in which the pattern may be imprinted using a master or template in a first imprint step. In some embodiments, the moldable layer is a radiation-curable material of less than 100$\mu$m thickness, such as 50 $\mu$m or less. The carrier polymer material 110 may be selected to have characteristics of high transparency for radiation penetration in the desired wavelength, such as a UV wavelength range, and toughness to be easily transported by means of a web. The sensitive radiation curable material of the moldable layer may be protected by another thin film of compatible material to protect the active surface of the moldable layer until the imprint process. A web management system in the imprint apparatus may be configured to remove the protective film just before imprinting. Once the imprint step is carried out to provide the pattern of the template into the moldable layer provided on the carrier polymer material 110, UV radiation may be provided, for instance thought the carrier polymer material 110, to cure the patterned surface material to form the cured layer 120 with the imprinted pattern as shown in Fig. 1.

In some embodiments, both the first and the second imprint steps may be carried out in the same imprint apparatus. In other embodiments, the ribbon-shaped polymer web 50 provided with imprint stamps 10 may be supplied on a roll into an imprint apparatus in which the second imprint step is carried out.

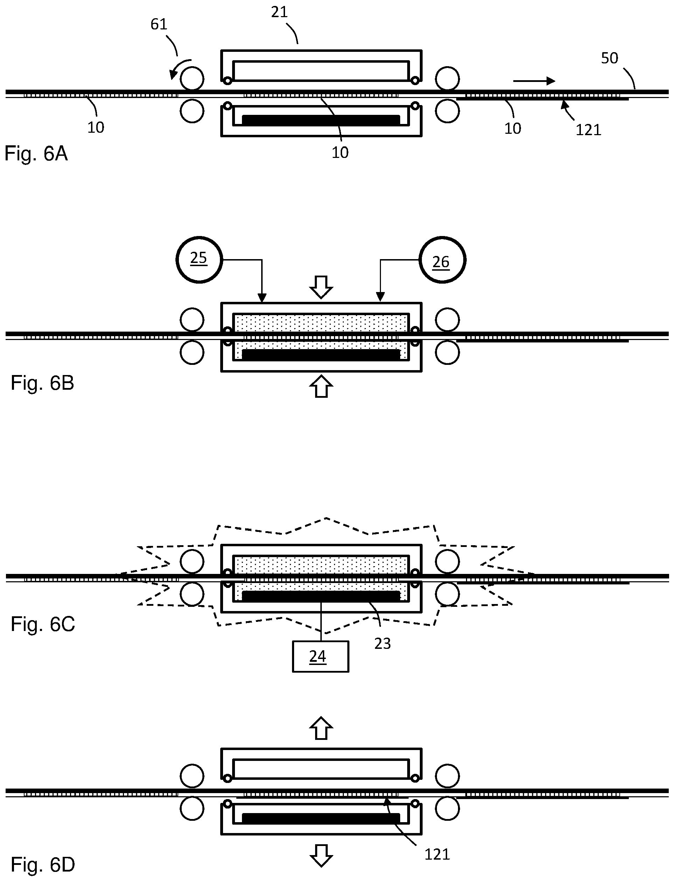

Figs 6A-6D schematically illustrate an embodiment of the surface treatment process as disclosed herein, as carried out on a patterned polymeric surface portion 11 of a web in the shape of a polymer ribbon 50, wherein the patterned surface 11 forms a stamp 10 which may be used as a polymer stamp in a second imprint step. It may be noted that in the embodiments illustrated in Figs 6-9, the stamps 10 are formed on the lower face of the polymer ribbon 50. Each stamp 10 formed on the polymer ribbon 50 are schematically illustrated by a dashed area. The drawings illustrate the plasma chamber 21 and a conveyor mechanism 61 indicated by means of rollers, configured to intermittently convey the polymer ribbon 50 through at least a process station where the surface treatment is carried out.

In Fig. 6A, the polymer ribbon 50 is conveyed such that an imprint stamp 10 is arranged between the two wall members 21A, 21B of the open plasma chamber 21. To the right, a previously coated stamp 10 on the polymer ribbon is located, having a coating 121, and to the left, a subsequent stamp 10 to be coated is located.

In Fig. 6B, the plasma chamber 21 closed by means of a closing mechanism, configured to clamp the chamber wall members 21A, 21B to a sealed engagement over the ribbon 50 such that the surface portion forming the imprint stamp 10 is enclosed in the chamber 21. At this point, a degassing step may be carried out, e.g. using the pressure control mechanism 26 and/or flushing the chamber cavity with a preprocessing gas, such as $N_2$ by operating the gas supply mechanism 25. Degassing is carried out for the purpose of purging the plasma chamber 21. The presence of oxygen can affect the plasma process in a negative way. This step of introducing N2 gas into the chamber and evacuating, increases the effectiveness of oxygen removal by the vacuum pump. This is specifically effective in situations where high-vacuum pumping, e.g. by using a turbo pump, is not employed.

Subsequently, the pressure control mechanism 26 is operated to provide a predetermined operating pressure in the chamber 21. In some embodiments, a vacuum level at which the plasma polymerisation is performed is typically controlled to between 10 to 20 Torr. The gas supply mechanism 25 is subsequently operated for introduction of the process gas into the plasma chamber 21. The process gas may comprise a plurality of components acting as precursors used for plasma polymerisation to form the coating. The process gas may comprise one or more of $CF_4$, $C_2F_6$, $C_3F_6$, $C_3F_8$, $C_4F_8$, $C_5F_{12}$, $C_6F_{14}$ and/or other saturated or unsaturated hydrocarbons $C_xF_y$. In some embodiments, the process gas may comprise siloxane, silane or silazane, or acrylate, methyl acrylate or mixtures thereof.

In Fig. 6C, the plasma process is carried out. The electrode 23 is fed with electrical energy from the power supply control device 24. The frequency of the plasma can be operated in the kHz, MHz, or GHz range, and it can be pulsed or continuous. Allowed frequencies for plasma generation include 40kHz (low frequency plasma), 13.56 MHz (Radio frequency plasma) and 2.45 GHz (microwave plasma). Various embodiments outlined herein may employs the 13.56 MHz - RF frequency for the coating processes, although other frequencies may alternatively be used. The power used is highly dependent on the monomer introduced into the chamber in the form of the process gas used but can typically vary from 1 to 49 W/ $dm^2$ of the electrode area and can be applied continuously or pulsed. In this process, a coating 121 is deposited on the stamp surface 11 by a low pressure plasma polymerisation process in the plasma chamber 21 through cross linking the monomer of the introduced process gas. Process parameters influencing the process, such as power, pressure, temperature, type of monomer in the process gas, flow, process time and frequency of the plasma generated, are controlled to obtain inter alia a desired material and thickness of the coating 121. When power supply to the electrode 23 is terminated the plasma polymerisation process halts. Excess gases may be flushed or purged using the gas supply mechanism 25 and/or the pressure control mechanism 26.

In Fig. 6D, the plasma chamber 21 is again opened. The polymer ribbon 50 may subsequently be conveyed such that the now coated imprint stamp 10 with the coating 121 is transported out, to the right, of the process station between two wall members 21A, 21B of the plasma chamber 21. The obtained coating 121 on the structured polymer stamp 10 enables a reduced surface energy $\sigma_{(polymer\ material-antisticked)}$. The thickness of the prepared coating 121 may in various embodiments by applied in the described low pressure plasma process to a selected thickness, such as 5-25 nm making it suitable for replication of structures with nm resolution.

The imprinted and coated polymer ribbon 50 may in some embodiments be cut up to separate coated stamps 10. In other embodiments, the polymer ribbon of coated stamps 10 may be rolled up to a ribbon roll comprising a plurality of coated stamps, for storage and subsequent use in a second imprint step.

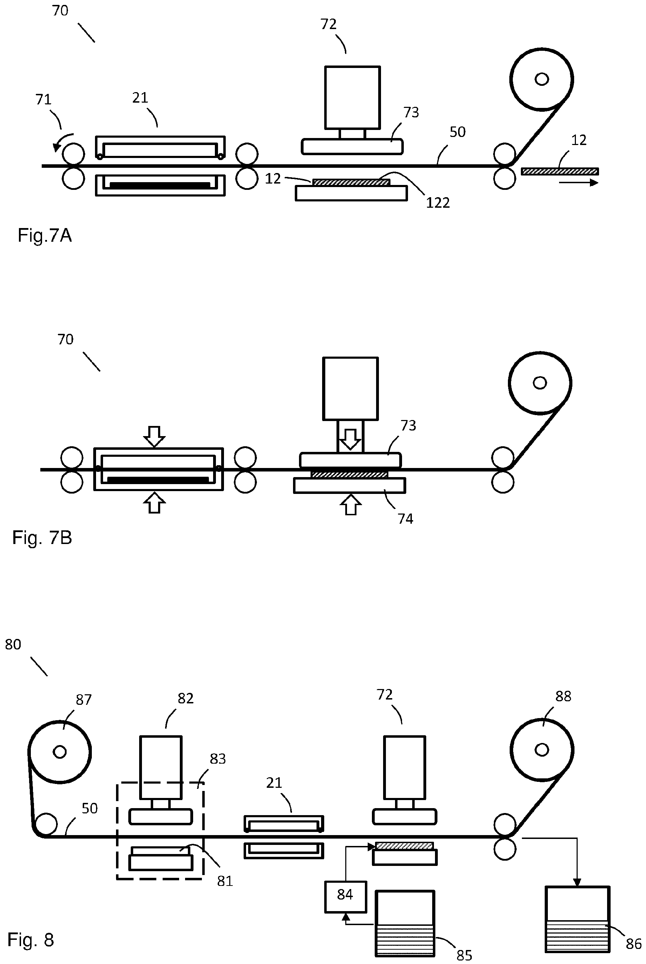

Figs 7A and 7B illustrate yet another embodiment, in which the plasma process station is comprised in an imprint apparatus 70. A conveyor mechanism 71, indicated by means of rollers, is configured to intermittently convey the polymer ribbon 50, comprising imprinted surface portions 11 forming respective polymer stamps 10, through the imprint apparatus 70. The imprint apparatus 70 comprises a sealed plasma chamber 21 for coating an imprint stamp in accordance with the methods outlined herein, to obtain a coating 121 on the structured stamp surfaces 11 on the imprint stamps 10. Moreover, the imprint apparatus comprises a substrate imprint station 72, configured to apply pressure to press a coated imprint stamp 10, which has been conveyed to the imprint station 72, against a substrate 12 to transfer a pattern of the coated stamp surface to a moldable layer on a target surface 122 of the substrate 12. The substrate is not shown in detail but may comprise e.g. be a semiconductor wafer on which a resist layer is provided for obtaining the desired pattern by imprint, using the polymer stamp 10. Moreover, in these drawings, the individual stamps 10 are not shown. Furthermore, the systems and devices supporting the process chamber 21, such as the gas supply mechanism 25, the pressure control mechanism 26, and the power supply control device 24, are left of for the sake of simplicity.

Fig. 7A shows a scenario where the polymer ribbon 50 is conveyed through the imprint apparatus 70 to a position where an uncoated stamp 10 is placed between the open chamber wall members 21A, 21B, and where a stamp 10 on the ribbon 50 which has already been provided with a coating in the plasma chamber 21 is placed at the imprint station 72, with its coated structured surface 11 opposite the resist forming a target surface 122 of the substrate 12.

Fig. 7B illustrates a scenario in which the plasma chamber 21 is closed and operated to provide a coating 121 on the stamp 10 present therein, as described. In conjunction therewith, the imprint station 72 is operated to apply pressure to press the coated structured pattern of the stamp surface 11 into the resist layer on the substrate 12. This may involve bringing a pressure member 73 towards a counter member 74 and applying pressure. Pressure may be applied by means of a gas pressure supplied to a pressure chamber (not shown) in the pressure member 73 and/or in the counter member 74, which pressure chamber has a membrane facing and engaging the sandwich structure of the connected stamp 10 and substrate 12. Heat and/or radiation may further be applied to harden or cure the thus imprinted resist layer on the substrate 12. Details of the imprint process are as such not described in any further detail and may be provided in accordance with state of the art procedures. Upon opening the plasma chamber 21 and separating the pressure member 73 and the counter member 74 of the imprint station, the conveyor mechanism 71 may again be operated to move a new uncoated stamp 10 into position between the chamber walls 21A, 21B, and a new coated stamp 10 into the imprint station 72.

In some embodiments, the imprinted substrate 12 may be conveyed from the imprint station 72 together with the polymer ribbon 50. The substrate may thereby be disassembled from the polymer ribbon 50, as indicated in Fig. 7A. Alternatively, a portion of the polymer ribbon 50 comprising the stamp 10 connected to the substrate 12 may be cut out from the polymer ribbon 50 and transported away with the substrate 12 still attached for subsequent disassembly. In yet another embodiment, disassembly of the substrate 12 from the polymer ribbon 50 is executed at the imprint station 72.

Fig. 8 schematically illustrates a two-step imprint apparatus 80, which comprises an intermediate surface treatment station comprising the plasma chamber 21. The imprint apparatus 80 comprises the features of Figs 7A and 7B, i.e. the plasma chamber 21 configured for coating an imprint stamp 10, and the substrate imprint station 72. Moreover, the imprint apparatus 80 comprises a stamp forming station 82, provided before the plasma chamber 21 in the processing order. The stamp forming station 82 may be configured and operate in accordance with the general principles of the substrate imprint station 72. As described previously, the stamp forming station 82 is operated to imprint the pattern of a template 81 in a surface layer of the polymer ribbon 50. The surface layer may be a radiation curable material provided on a support layer 110, which is cured at the stamp forming station 82 to provide the structured layer 120 on the stamp 10. The imprint apparatus 80 further comprises a demolding mechanism 83, configured to disassemble the imprint stamp 10 as formed from the template 81. The demolding mechanism 83 is arranged between the stamp forming station 82 and the plasma chamber 21, such that the demolded stamp 10 formed in the polymer ribbon 50 is subsequently conveyed to the process chamber 21. Further operation may be conducted in accordance with what was described with reference to Figs 6 and 7.

Fig. 8 further illustrates a substrate supply mechanism, which may likewise be employed in the embodiment of Figs 7A and 7B. The substrate supply mechanism may comprise a substrate supply source 85, such as a substrate cassette, and a supply operating mechanism 84 for providing a substrate 12 from the substrate supply source 85 to the substrate imprint station 72. The supply operating mechanism 84 may e.g. comprise a slide tray configured to insert a substrate 12 into position in the substrate imprint station 72 from the side, perpendicular to the direction of conveyance of the polymer ribbon 50. In some embodiments, a substrate collector mechanism 86 is further comprised, configured to collect an imprinted substrate which has been disassembled from the polymer ribbon 50. As described, this may in various embodiments comprise cutting out of the stamp 10 from the polymer ribbon 50, or demolding of the stamp 10 from the substrate 12.

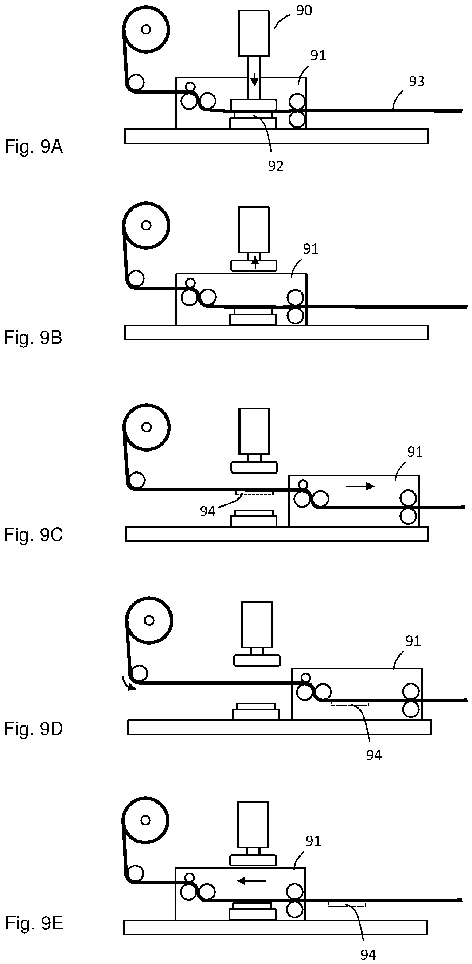

Figs 9A-9E schematically illustrate a system comprising an imprint station 90 and a demolding mechanism 91 arranged at the imprint station 90. Specifically, the drawings illustrate operation of the demolding mechanism 91, configured to disassemble an object 92 from a polymer ribbon 93. The disassembling, or demolding, is carried out subsequent to an imprint process executed in the imprint station 90 for pattern transfer between the object 92 and a surface portion of the polymer ribbon 93. In this context, the demolding mechanism 91 may be operated at the stamp forming imprint station 82 described with reference to Fig. 8. The demolding mechanism 91 may further be employed in various embodiments of a substrate imprint station 72 the as described with reference to Figs 7-8, where the substrate is held in the substrate imprint station 72, such by means of a chuck. In other words, a first member, being either the object 92 or the polymer ribbon 93, comprises a structured surface layer having a pattern, which is transferred to a second member, being the other of the object 92 and the polymer ribbon 93, by imprint into a moldable surface layer of that second member. The demolding process may e.g. be carried out in accordance with applicant's prior publication EP3037236A1.

In Fig. 9A, an imprint step is carried out in the imprint station 90, wherein the object 92 and the polymer ribbon 93 are held in a sandwich arrangement between a pressure member and a counter member, and pressure is applied.

In Fig. 9B, pressure is released, and the pressure member and a counter member are displaced away from each other. The object 92 and the polymer ribbon 93 are now attached together, as a result of engagement between the imprint structures of the first member and the formed replica pattern in the moldable layer of the other member, and partly as a result of adhesion between the surface materials of the object 92 and the polymer ribbon 93. The object 92 is held firmly in at the imprint station, e.g. at the counter member, by means of a chuck member or the like, mechanically and/or by suction.

In Fig. 9C, the demolding mechanism 91 slides past the imprint station 90 in the direction of the shown arrow, and thereby lifts the polymer ribbon 93 by means of a roller arrangement. By this action, the polymer ribbon 93 is peeled off and released from the object 92. A patterned structure 94 is schematically illustrated on the polymer ribbon 93 where it was engaged with the object 92.

In Fig. 9D, a conveyor mechanism drives the polymer ribbon 93, as illustrated by the arrow, such that the patterned structure 94 on the polymer ribbon is transported out of the imprint station 90.

In Fig. 9E, the demolding mechanism is again slid back to lower the polymer ribbon 93. At this point, or just before, the object 92 may also be replaced with another object. The system is now ready for the step of Fig. 9A again.

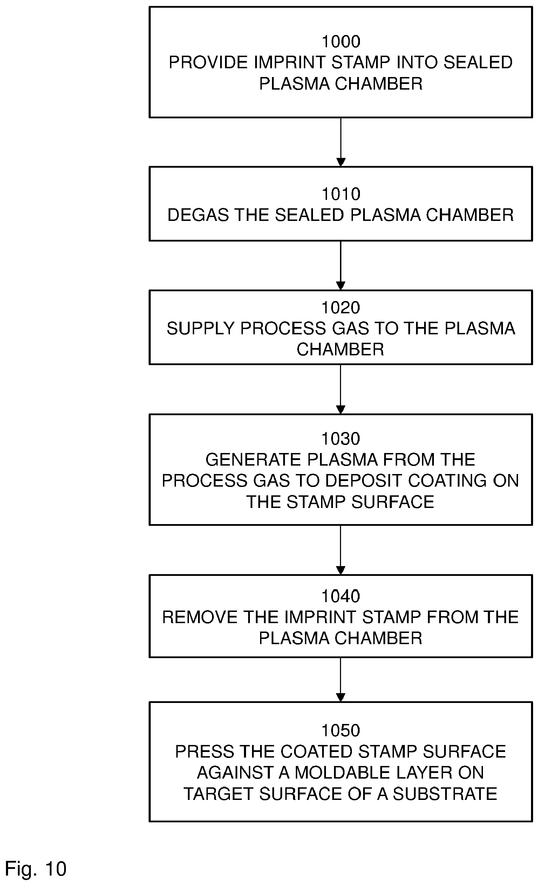

Fig. 10 shows a flowchart of various steps that may be included in a method for surface treatment of an imprint stamp 10 having a structured stamp surface 11 for use in nano imprint lithography.

In step 1000, the method may comprise providing the imprint stamp 10 into a sealed plasma chamber 21.

In step 1020, the method may comprise supplying a process gas to the plasma chamber 21.

In step 1030, the method may comprise generating a plasma from the process gas in the plasma chamber 21 to deposit a coating on the stamp surface 11.

In step 1040, the method may comprise removing the imprint stamp 10 from the plasma chamber 21.

The method may optionally comprise degassing the sealed plasma chamber 21 prior to supplying 1020 the process gas.

In various embodiments, the method of processing the imprint stamp in accordance with steps 1000-1050 may be incorporated in a method for transferring a pattern of a structured stamp surface 11 of an imprint stamp 10 onto a target surface 122 of a substrate 12. The method may thus comprise pressing 1050, in a substrate imprint stage, e.g. at the imprint station 72, the coated stamp surface 11 against a moldable layer on the target surface 122 of the substrate 12.

In various embodiments, the imprint stamp 10 is formed on a surface portion of a polymer ribbon 50 which acts as a stamp carrier, wherein providing 1000 the stamp 10 into the sealed chamber 21 comprises:

conveying said ribbon 50 through a process station 70 where the imprint stamp is arranged between two wall members 21A, 21B of the plasma chamber 21;
closing the chamber wall members 21A, 21B to a sealed engagement over the ribbon 50 such that the surface portion forming the imprint stamp 10 is enclosed in the chamber 21.

The general step of pressing 1050 may comprise conveying said ribbon 50, subsequent to processing the imprint stamp 1000-1030, to provide the imprint stamp 10 at a substrate imprint station 72 for said substrate imprint stage.

In some embodiments, the method for transferring a pattern may comprise steps of creating the imprint stamp, e.g. at the station 82, prior to providing the imprint stamp 10 into the chamber 21. That method may comprise:

pressing, in a stamp forming stage, a structured surface of a template 81 onto a surface of the stamp carrier 50 to create said imprint stamp 10 with said structured surface, and
disassembling the imprint stamp 10 from the template 81.

The method steps as outlined above may be carried out in accordance with any of the embodiments outlined above.

Various embodiments have been described herein, within the context of the proposed solution as provided by the terms of the independent claims. The proposed solution employs low-pressure plasma processing for surface treatment of a stamp 10 used for imprint. This way of obtaining improved anti-sticking properties offers a rapid, yet clean process that is beneficial to the environment, and suitable for application in an imprint apparatus. Applicant has managed a process time of less than 2 min for the surface treatment process on a polymer stamp, using an embodiment of the described process. When the proposed solution is employed on an intermediate polymer stamp 10, the antistick coating 121 on the intermediate polymer stamp 10 reduces the demolding force after using the coated intermediate polymer stamp 10 in a second imprint step on a substrate 12, resulting in several advantages. Primarily, since the shear forces are low, the resulting imprinted substrate is cleaner with fewer particles ripping off the polymer stamp 10. Applicant has seen that excellent replication fidelity is achieved even for high aspect ratio structures. Dependent on the use case and the exact imprint technology, high aspect ratio, of depth relative to width of the imprint structures, may mean at least 3:2, 5:1, 10:1 or more. As an additional benefit, the intermediate polymer stamp 10 may now be used multiple times, which in turn increases the lifetime of the more expensive master template 81. Demolding, after imprint using the coated intermediate polymer stamp 10, becomes more robust reducing the need for complex mechanical systems in an automated tool. Demolding may for instance be carried out according to the principles laid out with reference to Fig. 9, or manually. The coating creates a physical barrier, thus enabling even similar materials to be used both in the polymer template and the resist. This creates a larger freedom of selecting materials for use in the imprint process. Examples of such similar material include for instance a PMMA polymer template (IPS) used to imprint in an acrylate based UV resin, a PC IPS used to imprint in an epoxy based UV curable photoresist, and an acrylate based UV curable resin on the IPS, used to imprint on an epoxy based photoresist.

Examples

Various examples carried out in accordance with the proposed solution are outlined below. As a master template 81, a metal template provided with a SAM (Self-Assembled Monolayer) anti-adhesion layer has been used. The template is preferable made of nickel, although alternative embodiments may be made of e.g., vanadium, aluminium, tantalum, niobium, zirconium, or titanium. The anti-adhesive layer comprises of a fluorinated alkyl phosphoric acid derivative or a fluorinated alkyl polyphosphoric acid derivative, including a phosphorous atom and an alkyl chain. As an alternative to such anti-adhesion layer, a layer comprising silane groups, phosphate groups or carboxylic groups may be used.
In various examples, the polymer foil 50 onto which the stamp 10, or IPS, is formed in the first step, comprises a UV curable pressure-sensitive adhesive or PSA. With reference to Fig. 1, which shows the foil 50 already having an imprinted stamp 10, the foil 50 may comprise a UV curable resin with a thickness of 120 of 10-100 $\mu$m, such as about 30 $\mu$m, coated onto a PET backing material 110. The backing material 110 may be thicker than the coating 120, such as 100-200 $\mu$m, e.g. 150 $\mu$m. The photo-resist material 120 is curable after exposure to light having wavelengths between 350 and 400 nm.
A resist material from micro resist GmbH mr NIL-6000 was used in the second step, applied onto the substrate.
An Eitre 500 tool manufactured by Obducat Technologies AB, Sweden was used to perform the imprints in the first and the second steps. The tool houses an imprint area of 500x500 mm2 with inline UV curing capability of 4000 mJ/cm2. In some examples, the tool also houses a de-molding unit for mechanical mold separation, as illustrated in Fig. 9.

Example 1

A nickel template whose surface exhibits a BluRay pattern having structure height of 100 nm has been used as the master template. The BluRay pattern is then transferred in the first step into an optically clear PMMA sheet of 125$\mu$m thickness at 165°C and 50 bar for 3 min. The PMMA sheet was mechanically removed from the template surface without damaging the pattern of neither the stamp nor the replica. This PMMA template is then manually placed in a plasma chamber 21 to suitably coat the patterned surface with a plasma polymerised anti-sticking layer. The glow plasma is observed to be most stable at operating pressures of 110 - 190 mTorr. However other electrode and chamber designs could also enable successful plasma polymerisation at pressures as high at 15 Torr. Thereafter, the coated PMMA polymer stamp 10 was imprinted into a 100 nm thick resist, spin-coated onto a silicon substrate 12. The imprint was performed at 65°C and 35 bar for 3 minutes. UV exposure was performed simultaneously while maintaining the polymer stamp 10 and the substrate 12 under pressure. Mold release was manually performed at 65°C.

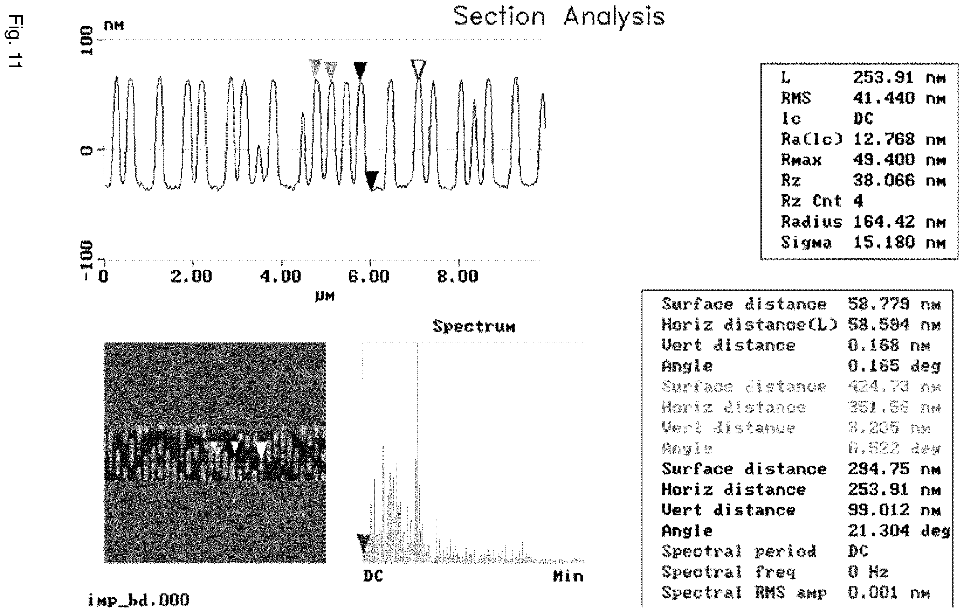

Fig. 11 shows an AFM (Atomic Force Microscope) image of an imprint result in an NIL-6000 resist spin-coated on a silicon wafer 12, manufactured by the process described. In the lower data box, the first 4 rows of data refer to the open triangles in the AFM diagram, the second four rows of data belong to the grey triangles, and the third four rows of data belong to the black triangles. The final rows of data relate to the spectrum diagram.

Example 2

A Ni template whose surface exhibits a line pattern has been imprinted into a foil 50 comprising a 30 $\mu$m layer of a UV curable resin 120, as outlined above, in the first step to create the polymer template 10, or IPS. The Ni surface may be pre-treated for an anti-adhesion layer. The dimensions of the Ni template are 500x500 mm2. The Eitre 500 tool with automated web handling was used for imprinting both steps, and further houses an integrated plasma coating system as described herein. The Ni template has a line pattern with 150 nm line and 400 nm pitch over a minimum of 400 X 400 mm2 area. Glass substrates measuring 370 X 470 mm2 of thickness 0.5 mm were spin coated with resist for imprinting. The IPS and substrate lamination and de-moulding are performed automatically by roll demolding, as outlined in Fig. 9, using a demolding mechanism integrated into the large-area imprint tool. The IPS is made by imprinting the foil 50 at room temperature at 15 bar pressure for 2 minutes. Then the material is cured with UV light for 5 seconds under pressure. The IPS is now introduced into the plasma chamber mentioned in this invention. The plasma polymerization for the coating of the anti-sticking layer of the IPS is similar to the process described in Example 1. The coated IPS is then imprinted onto a glass substrate coated with the NIL-6000 resist. The substrate imprinting was performed at 65°C for 2 minutes at 15 bar pressure.

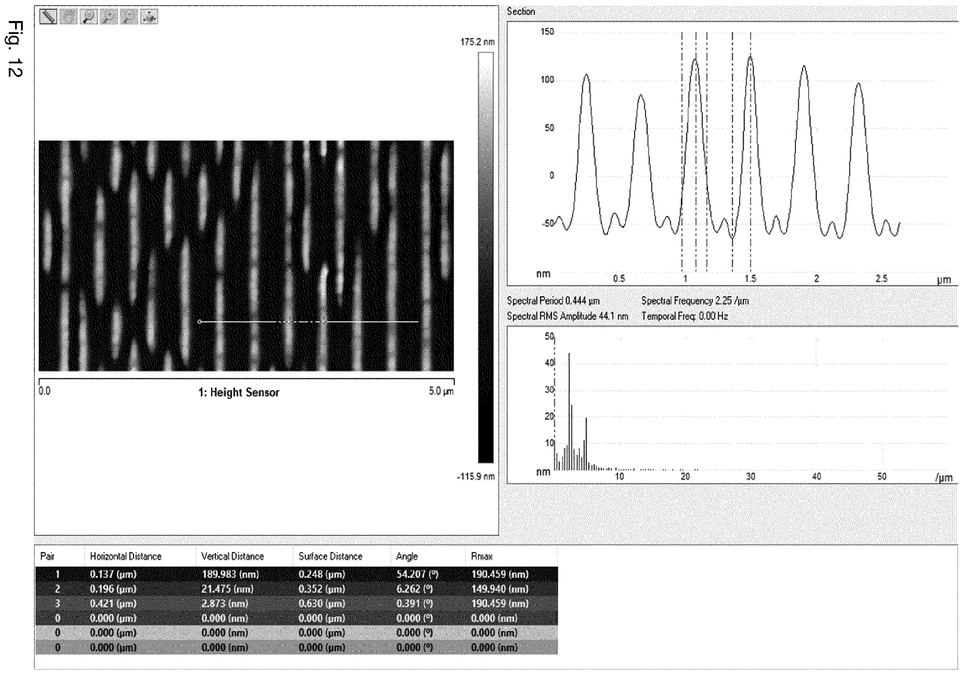

The AFM image of the imprint result in the resist is shown in Fig. 12.

Example 3

An intermediate stamp 10, such as an IPS, is prepared by spin-coating a UV curable material on a suitable carrier of plastic or glass. Examples of plastic materials include, but are not limited to, PC, PMMA, PET. The IPS is imprinted in the first step and cured towards a master stamp leaving a polymer replica with the same parameters as mentioned in Example 2. The IPS is manually separated from the stamp and is placed in a plasma CVD chamber, as outlined herein, where its patterned surface is coated with a low surface energy layer 5-20 nm thick, with good uniformity and coverage. The process conditions for such a coating are like the parameters mentioned in Example 1. In the second step, the coated IPS is then imprinted onto a substrate coated with a UV curable material like the NIL-6000 resist using the same parameters as mentioned in Example 1. The UV curable composition coated on the IPS carrier is formulated for having a high modulus so it can replicate demanding structures. The main ingredient of the UV-curable composition has an aromatic backbone, giving a high modulus to the finished product. A 150 mm Si stamp with a line pattern of 138 nm height and 400 nm pitch has been used.

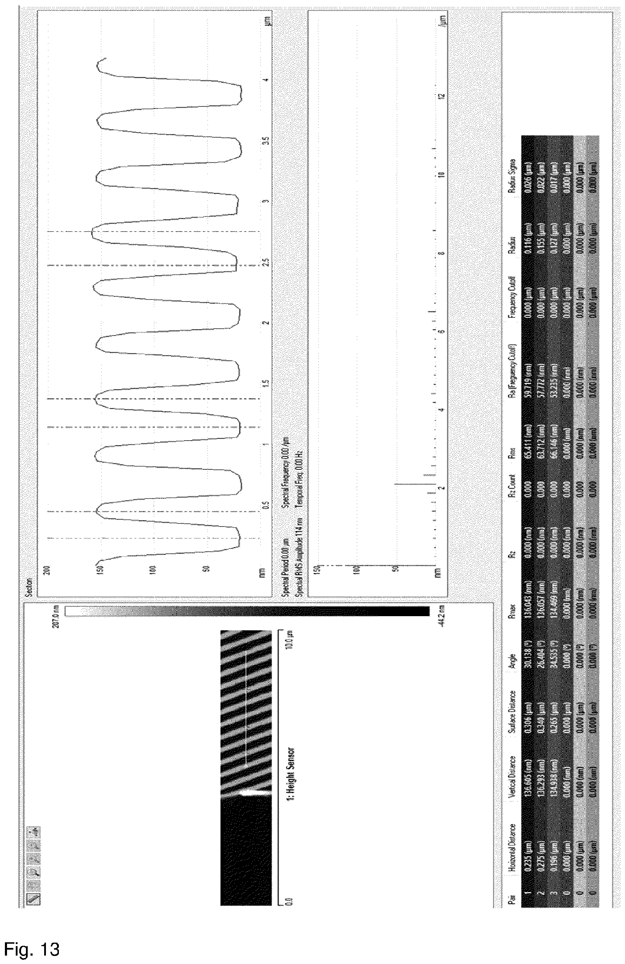

The results of the imprint on the substrate have been measured with AFM and is depicted in Fig 13.

**Claims**

1. A method for surface treatment of an imprint stamp having a structured stamp surface for use in nano imprint lithography, comprising:

   providing (1000) the imprint stamp into a sealed plasma chamber;
   supplying (1020) a process gas to the plasma chamber;
   generating (1030) a plasma from the process gas in the plasma chamber to deposit a coating on the stamp surface;
   removing (1040) the imprint stamp from the plasma chamber.

2. The method of claim 1, wherein the coating provides decreased surface energy of the thus coated stamp surface.

3. The method of claim 1 or 2, comprising:
   degassing (1010) the sealed plasma chamber prior to supplying the process gas.

4. The method of any preceding claim, wherein the plasma is generated at a plasma chamber pressure of 10-1000 mTorr.

5. The method of any preceding claim, wherein the plasma is generated by supplying an electric field to an electrode in the plasma chamber.

6. The method of any preceding claim, wherein said process gas comprises a hydrofluorocarbon ($C_xF_y$) monomer material.

7. The method of any preceding claim, wherein said process gas comprises a siloxane, silane, silazane or mixtures thereof.

8. The method of any preceding claim, wherein said process gas comprises an acrylate, methyl acrylate or mixtures thereof.

9. The method of any preceding claim, wherein said coating has a thickness of 5-25 nm.

10. The method of any preceding claim, wherein the structured stamp surface is formed in a cured polymer layer of the imprint stamp.

11. The method of claim 10, wherein the imprint stamp comprises a polymer body of a first polymer material, onto which polymer body said polymer layer is formed of a second polymer material.

**12.** A method for transferring a pattern of a structured stamp surface of an imprint stamp onto a target surface of a substrate, comprising:

processing the imprint stamp in accordance with any of the preceding claims; and
pressing (1050), in a substrate imprint stage, the coated stamp surface against a moldable layer on the target surface of the substrate.

**13.** The method of claim 12, wherein the imprint stamp is formed on a surface portion of a polymer ribbon which acts as a stamp carrier, wherein providing the stamp into the sealed chamber comprises:

conveying said ribbon through a process station where the imprint stamp is arranged between two wall members of the plasma chamber;
closing the chamber wall members to a sealed engagement over the ribbon such that the surface portion forming the imprint stamp is enclosed in the chamber.

**14.** The method of claim 13, comprising:
conveying said ribbon, subsequent to processing the imprint stamp, to provide the imprint stamp at a substrate imprint station for said substrate imprint stage.

**15.** The method of claim 13 or 14, comprising, prior to processing the structured surface:

pressing, in a stamp forming stage, a structured surface of a template onto a surface of the stamp carrier to create said imprint stamp with said structured surface;
disassembling the imprint stamp from the template.

**16.** An imprint apparatus (70), comprising:

a sealed plasma chamber (21) configured for coating an imprint stamp (10) held in the chamber by plasma generation of a process gas, to obtain a coated structured stamp surface (11) on the imprint stamp;
a substrate imprint station (72), configured to apply pressure to press the coated imprint stamp against a substrate (12) to transfer a pattern of the stamp surface to a moldable layer on a target surface (122) of the substrate.

**17.** The imprint apparatus of claim 16, wherein the imprint stamp (10) is formed on a surface portion of a polymer ribbon (50) which acts as a stamp carrier, the apparatus comprising:

a conveyor mechanism (71) configured to intermittently convey the polymer ribbon through a process station where the imprint stamp is arranged between two wall members (21A, 21B) of the plasma chamber;
wherein the plasma chamber comprises a closing mechanism (27) configured to clamp the chamber wall members to a sealed engagement over the ribbon such that the surface portion forming the imprint stamp is enclosed in the chamber.

**18.** The imprint apparatus of claim 17, wherein the conveyor mechanism is configured to convey said ribbon to transport the imprint stamp from the process station to the substrate imprint station.

**19.** The imprint apparatus of claim 17 or 18, comprising:

a stamp forming station (82, 90), configured to apply pressure to press a template onto a surface of a stamp carrier to create said imprint stamp with said structured surface; and
a demolding mechanism (91) for disassembling the imprint stamp from the template prior to transporting the imprint stamp to the plasma chamber.

**20.** The imprint apparatus of any of claims 16-19, configured to operate in accordance with any of claims 2-15.

Fig. 1

Fig. 2

Fig. 3A

Fig. 3B

Fig. 4

Fig. 5

61    21                                           50
10                                          10    121

Fig. 6A

25    26

Fig. 6B

24    23

Fig. 6C

121

Fig. 6D

Fig.7A

Fig. 7B

Fig. 8

Fig. 9A

Fig. 9B

Fig. 9C

Fig. 9D

Fig. 9E

```
┌─────────────────────────────────────┐
│               1000                   │
│   PROVIDE IMPRINT STAMP INTO SEALED  │
│           PLASMA CHAMBER             │
└─────────────────────────────────────┘
                   │
                   ▼
┌─────────────────────────────────────┐
│               1010                   │
│    DEGAS THE SEALED PLASMA CHAMBER   │
└─────────────────────────────────────┘
                   │
                   ▼
┌─────────────────────────────────────┐
│               1020                   │
│   SUPPLY PROCESS GAS TO THE PLASMA   │
│              CHAMBER                  │
└─────────────────────────────────────┘
                   │
                   ▼
┌─────────────────────────────────────┐
│               1030                   │
│      GENERATE PLASMA FROM THE        │
│  PROCESS GAS TO DEPOSIT COATING ON   │
│         THE STAMP SURFACE            │
└─────────────────────────────────────┘
                   │
                   ▼
┌─────────────────────────────────────┐
│               1040                   │
│   REMOVE THE IMPRINT STAMP FROM THE  │
│           PLASMA CHAMBER             │
└─────────────────────────────────────┘
                   │
                   ▼
┌─────────────────────────────────────┐
│               1050                   │
│    PRESS THE COATED STAMP SURFACE    │
│    AGAINST A MOLDABLE LAYER ON       │
│   TARGET SURFACE OF A SUBSTRATE      │
└─────────────────────────────────────┘
```

Fig. 10

Fig. 11

## Section Analysis

nm

100

0

-100

0    2.00    4.00    6.00    8.00

µm

| L | 253.91 nm |
|---|---|
| RMS | 41.440 nm |
| lc | DC |
| Ra(lc) | 12.768 nm |
| Rmax | 49.400 nm |
| Rz | 38.066 nm |
| Rz Cnt | 4 |
| Radius | 164.42 nm |
| Sigma | 15.180 nm |

Spectrum

DC          Min

imp_bd.000

| Surface distance | 58.779 nm |
|---|---|
| Horiz distance(L) | 58.594 nm |
| Vert distance | 0.168 nm |
| Angle | 0.165 deg |
| Surface distance | 424.73 nm |
| Horiz distance | 351.56 nm |
| Vert distance | 3.205 nm |
| Angle | 0.522 deg |
| Surface distance | 294.75 nm |
| Horiz distance | 253.91 nm |
| Vert distance | 99.012 nm |
| Angle | 21.304 deg |
| Spectral period | DC |
| Spectral freq | 0 Hz |
| Spectral RMS amp | 0.001 nm |

EP 4 057 066 A1

Fig. 12

Fig. 13

Europäisches
Patentamt

European
Patent Office

Office européen
des brevets

# EUROPEAN SEARCH REPORT

Application Number

EP 21 16 1914

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/164475 A1 (MEYER JUSTIN P [US] ET AL) 14 June 2018 (2018-06-14) | 1-12,16, 20 | INV. G03F7/00 |
| Y | * paragraphs [0107] - [0109], [0121] - [0124], [0314], [0316], [0321] - [0334] * | 13-15, 17-20 | |
| X | CN 103 436 853 B (SUZHOU JINYUAN NANO SCIENCE & TECHNOLOGY CO LTD) 16 March 2016 (2016-03-16) | 1-6, 9-12,16, 20 | |
| Y | * paragraphs [0005], [0008] - [0016], [0028] - [0030] * | 13-15, 17-20 | |
| Y | US 2007/134362 A1 (HEIDARI BAKAK [SE]) 14 June 2007 (2007-06-14) * paragraphs [0120] - [0127]; figures 24-27 * | 13-15, 17-20 | |
| Y | WO 2017/099492 A1 (GIGALANE CO LTD [KR]) 15 June 2017 (2017-06-15) * paragraphs [0013] - [0040], [0100] - [0127]; figure 6 * | 13-15, 17-20 | |
| A | US 2006/158651 A1 (WATTS MICHAEL P [US] ET AL) 20 July 2006 (2006-07-20) * paragraphs [0132] - [0134] * | 1-3,7,9, 16 | TECHNICAL FIELDS SEARCHED (IPC) G03F |

The present search report has been drawn up for all claims

| Place of search | Date of completion of the search | Examiner |
|---|---|---|
| Munich | 27 August 2021 | Roesch, Guillaume |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 21 16 1914

This annex lists the patent family members relating to the patent documents cited in the above-mentioned European search report.
The members are as contained in the European Patent Office EDP file on
The European Patent Office is in no way liable for these particulars which are merely given for the purpose of information.

27-08-2021

| Patent document cited in search report | | Publication date | Patent family member(s) | | Publication date |
|---|---|---|---|---|---|
| US 2018164475 | A1 | 14-06-2018 | CN | 107810433 A | 16-03-2018 |
| | | | EP | 3317090 A1 | 09-05-2018 |
| | | | JP | 2018521357 A | 02-08-2018 |
| | | | TW | 201718241 A | 01-06-2017 |
| | | | US | 2018164475 A1 | 14-06-2018 |
| | | | WO | 2017003787 A1 | 05-01-2017 |
| CN 103436853 | B | 16-03-2016 | NONE | | |
| US 2007134362 | A1 | 14-06-2007 | AT | 549294 T | 15-03-2012 |
| | | | CN | 1979336 A | 13-06-2007 |
| | | | EP | 1795497 A1 | 13-06-2007 |
| | | | HK | 1107804 A1 | 18-04-2008 |
| | | | JP | 4942994 B2 | 30-05-2012 |
| | | | JP | 2007165812 A | 28-06-2007 |
| | | | MY | 149332 A | 30-08-2013 |
| | | | SG | 133485 A1 | 30-07-2007 |
| | | | TW | I392592 B | 11-04-2013 |
| | | | US | 2007134362 A1 | 14-06-2007 |
| WO 2017099492 | A1 | 15-06-2017 | NONE | | |
| US 2006158651 | A1 | 20-07-2006 | CN | 1997869 A | 11-07-2007 |
| | | | US | 2004021866 A1 | 05-02-2004 |
| | | | US | 2006158651 A1 | 20-07-2006 |

**EP 4 057 066 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1959299 A2
- EP 1795497 A1
- EP 3037236 A1